(19) Europäisches Patentamt / European Patent Office / Office européen des brevets

(11) **EP 4 726 720 A1**

(12) **EUROPEAN PATENT APPLICATION**

(43) Date of publication:
**15.04.2026 Bulletin 2026/16**

(21) Application number: **25207229.3**

(22) Date of filing: **07.10.2025**

(51) International Patent Classification (IPC):
**G11C 7/04** *(2006.01)*  **G11C 11/16** *(2006.01)*
**G11C 29/02** *(2006.01)*  **G11C 29/42** *(2006.01)*
**G11C 29/20** *(2006.01)*  **G01K 7/16** *(2006.01)*

(52) Cooperative Patent Classification (CPC):
**G11C 7/04; G11C 11/1673; G11C 29/021;**
**G11C 29/028; G11C 29/42; G01K 7/16;**
G01K 2217/00; G11C 29/20; G11C 2029/0409

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **11.10.2024 US 202418912997**

(71) Applicant: **NXP USA, Inc.**
**Austin, TX 78735 (US)**

(72) Inventors:
• **Choy, Jon Scott**
**5656AG Eindhoven (NL)**
• **Roy, Anirban**
**5656AG Eindhoven (NL)**
• **Storms, Maurits Mario Nicolaas**
**5656AG Eindhoven (NL)**
• **Hadad, Daniel**
**5656AG Eindhoven (NL)**
• **Rinkenberger, Glenn Eric**
**5656AG Eindhoven (NL)**
• **Prosperi, Katrina Marie**
**5656AG Eindhoven (NL)**

(74) Representative: **Miles, John Richard**
**NXP Semiconductors**
**Intellectual Property Group**
**The Cattle Barn, Upper Ashfield Farm**
**Hoe Lane**
**Romsey, Hampshire SO51 9NJ (GB)**

(54) **TEMPERATURE SENSOR IMPLEMENTED WITH A MAGNETORESISTIVE RANDOM ACCESS MEMORY (MRAM)**

(57) Built-in self-test circuitry is configured to calculate a sensed temperature using an MRAM and a stored set of margin read reference and temperature correlations for a target bit error rate. A current margin read reference is selected, and a sweep through a sequence of addresses of the MRAM is performed using the current margin read reference. At each address of the sequence, a normal read is performed to obtain normal read data and a margin read is performed to obtain margin read data. A bit error count is obtained for the sweep based on comparisons between the normal and margin read data obtained at each address, and the current margin read reference is selectively modified based on whether or not the bit error count achieves the target bit error rate. The selectively modified current margin read reference and the stored set of correlations are used to calculate the sensed temperature.

FIG. 4

EP 4 726 720 A1

**Description**

Background

Field

This disclosure relates generally to temperature sensors, and more specifically, to a temperature sensor implemented with an magnetoresistive random access memory (MRAM).

Related Art

Today, on-chip temperature sensors are used for a variety of applications. However, typical temperature sensors are complex and require specific hardware. Therefore, a need exists for on chip temperature sensing that can be incorporated with minimal increase in cost or complexity.

Brief Description of the Drawings

The present invention is illustrated by way of example and is not limited by the accompanying figures, in which like references indicate similar elements. Elements in the figures are illustrated for simplicity and clarity and have not necessarily been drawn to scale.

FIG. 1 illustrates, in block diagram form, an integrated circuit having an MRAM and built-in self-test (BIST) circuitry for testing the memory, in which the BIST circuitry also includes temperature sensing circuitry, in accordance with one embodiment of the present invention.

FIG. 2 illustrates, in diagrammatic form, a bit cell distribution of resistances (and corresponding currents) for an MRAM array, in accordance with one embodiment of the present invention.

FIG. 3 illustrates, in diagrammatic form, bit cell distributions of failed bits versus a percentage or margin offset for an MRAM array across different temperatures, in accordance with one embodiment of the present invention.

FIG. 4 illustrates, in flow diagram form and block diagram form, a further detailed view of the BIST circuitry of FIG. 1 and a method of implementing temperature sensing by the BIST circuitry and MRAM of FIG. 1, in accordance with one embodiment of the present invention.

FIG. 5 illustrates, in flow diagram form, a method of performing temperature sensing, in accordance with an embodiment of the present invention.

FIG. 6 illustrates, in flow diagram form, a method for obtaining information during production testing for use by the temperature sensing of FIGs. 4 and 5, in accordance with an embodiment of the present invention.

Detailed Description

In one aspect, a BIST circuit performs temperature sensing using an MRAM as well as previously determined margin read reference and temperature correlations stored within a non-volatile memory (NVM). In one embodiment, the margin read reference and temperature correlations correspond to a set of margin read reference and temperature correlations along with an expected target number of bit errors at each margin read reference and temperature correlation. The margin read reference and temperature correlations can be determined and stored in the NVM during manufacture and production test of the MRAM. After manufacture, during normal operation of the MRAM, temperature sensing can be performed by the BIST circuit, as needed, using the MRAM and the stored margin read reference and temperature correlations.

For example, in one embodiment, the BIST circuit performs address sweeps at selected margin read references by sequencing through a range of addresses of the MRAM in which both a normal read (using a normal read reference, as used during normal operation of the MRAM) and a margin read (using a margin read reference that is offset from the normal read reference) are performed at each address. The read data for the two reads are compared, and a number of bit errors determined from the comparison is stored during each sweep. If the bit errors counted at the end of a sweep does not match the target number of bit errors, then the margin read reference is adjusted and an address sweep is again performed. The adjustment of the margin read reference for each subsequent sweep continues until the number of bit errors at the end of a sweep matches the target number of bit errors. At this point, the margin read reference which resulted in the target number of bit errors can be used, in combination with the stored margin read reference and temperature correlations to perform temperature interpolation to calculate a current temperature of the MRAM (and thus of the IC containing the MRAM). This temperature sensing provides flexibility by reusing an existing MRAM, without affecting its data or requiring that specific data be stored in the MRAM.

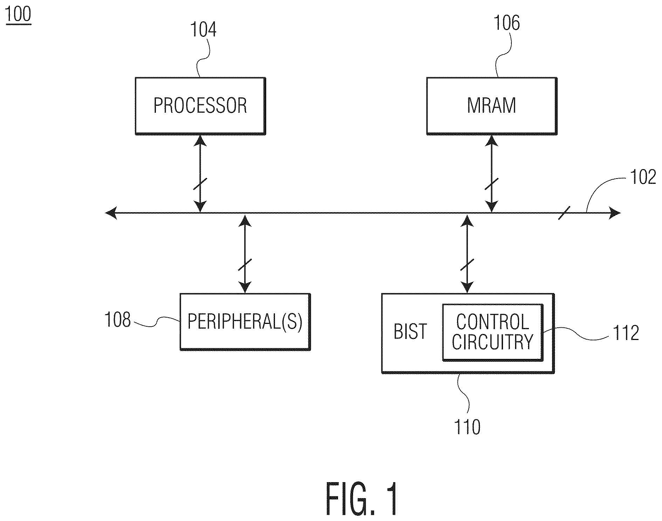

FIG. 1 illustrates an integrated circuit (IC) 100 which includes a processor 104, an MRAM 106, peripheral(s) 108, built-in self-test (BIST) circuitry 110, and a system interconnect 102. In one embodiment, IC 100 may be a system on a chip (SoC) which is integrated onto a single IC. Therefore, IC 100 can also be referred to as a system or an SoC. BIST circuitry 110 (also referred to as BIST 110) includes circuitry for testing MRAM 106 and a temperature sensor for sensing temperatures using MRAM 106. BIST circuitry 110 may also include circuitry for testing other memories or other circuits of IC 100. BIST circuitry 110 includes control circuitry 112 which may perform sequences of test or temperature sensing operations on MRAM 106. BIST 110 may also include storage circuitry (e.g. non-volatile memory (NVM), one-time programmable (OTP) memory, etc.) to store various parameters, as needed. BIST 110 can also be located as part of MRAM 106 or elsewhere within IC 100. System interconnect 102 can be any type of interconnect, such as, for example, a bus, a cross-bar switch, an interconnect network or fabric, etc. IC 100 may include any number of devices, such as any number of processors, any number of memories (which may include any type of memory, such as non-volatile or volatile memories), and any number of peripherals (or no peripherals at all). Therefore, IC 100 may include more or fewer elements than those illustrated in FIG. 1.

MRAM 106 may be implemented and operated, as known in the art, to store data, such as user data or user code. In one embodiment, MRAM 106 is arranged as an array of rows (along word lines) and columns (along bit line/source line pairs), in which the intersection of each row (word line) and column (bit line/source line pair) has a corresponding MRAM cell (i.e. memory cell or bit cell) having a select transistor and a magnetic tunnel junction (MTJ). The MTJ typically includes a conductive contact layer, a pinned magnetic layer, a tunnel dielectric layer, and a free magnetic layer. The magnetization direction of the pinned layer is fixed, while the magnetization direction of the free layer can be programmed to be in a parallel (p) direction or an anti-parallel (ap) direction to the magnetization direction of pinned layer in order to place the cell into a low resistive state (LRS) or a high resistive state (HRS), respectively. When the magnetization direction of free layer is in an anti-parallel direction, the resistance of the MTJ (referred to as Rap) is at a relatively high value, corresponding to the HRS. When the magnetization direction of free layer is in a parallel direction, the resistance (referred to as Rp) of the MTJ is of a relatively lower value, corresponding to the LRS. In one embodiment, the HRS corresponds to storing "1" in the memory cell, and the LRS to storing "0."

MRAM 106 also includes read circuitry with sense amplifiers. During a normal read of a selected memory cell, the sense amplifier, coupled to both the array bit line of the selected cell and to a reference resistance of a reference cell that is in between the high resistive value and the low resistive value, can determine whether a one "1" value (e.g. HRS) or a zero "0" value (e.g. LRS) is stored in the MTJ. As will be described below, to determine the state of a selected cell during a read operation, comparative resistances may be sensed between the selected cell and the reference cell, or alternatively, comparative currents or voltages between the selected cell and the reference cell may sensed, depending on the implementation of the read circuitry and the sense amplifiers, as known in the art. Note that in alternate embodiments, the HRS may instead correspond to a zero value and the LRS to a one value, however, for the embodiments discussed herein, it is assume that the HRS corresponds to the one value.

During a normal write operation to an MRAM cell, the magnetization direction of the free layer can be set by applying a voltage differential of sufficient magnitude across the MTJ to generate the desired current density for setting the magnetization direction of free layer. In one embodiment, the magnetization direction of free layer can be set in one direction by applying a higher voltage to a corresponding array bit line and a lower voltage to a corresponding source line while a select transistor is conductive, and can similarly be set in the other direction by applying the lower voltage to the corresponding array bit line and the higher voltage to the corresponding array source line while the select transistor is conductive. That is, current in a first direction through the MTJ programs the MTJ to a first logic state, and current in a second direction, opposite to the first direction, programs the MTJ to a second logic state. In this manner, an MRAM cell can be programmed to the HRS (i.e. Rap) or LRS (i.e. Rp), to store a "1" or a "0."

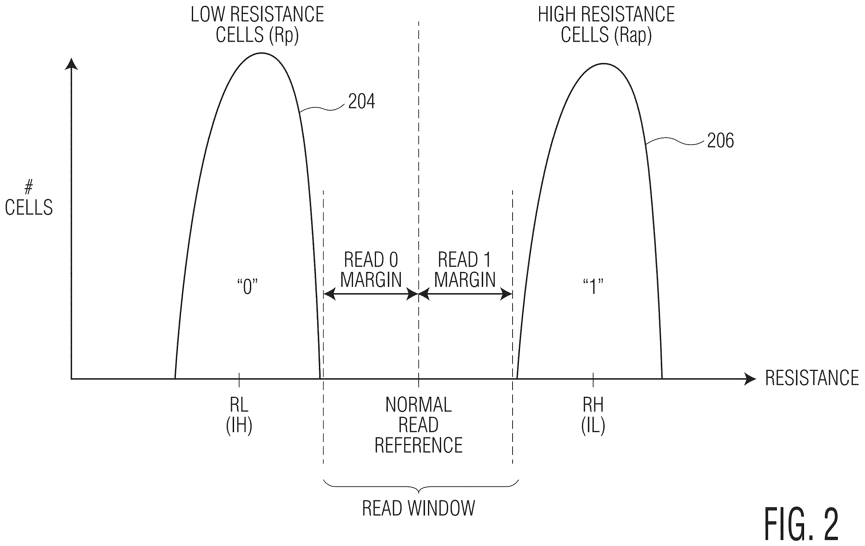

FIG. 2 illustrates a graph showing a distribution of resistances of cells of an MRAM array (such as that of MRAM 106) according to an embodiment of the present invention. The resulting cell current values are on the X axis (which varies linearly with resistance, such that the cell current decreases as the cell resistance increases) and the number of cells having a particular resistance is on the Y axis. FIG. 2 shows the resistance distribution for cells of an array that are either in the HRS (Rap cells which store a "1") or LRS (Rp cells which store a "0").

In the embodiment shown, the low resistance state cells have a resistance distribution 204 centered on resistance RL (in which the low resistance RL corresponds to a high current IH), and the high resistance state cells have a resistance distribution 206 centered on resistance RH (corresponding to a low current IL). Note that the distribution 204 may be referred to as the "0" distribution and distribution 206 as the "1" distribution. The normal read reference resistance can be centered half way between RL and RH to distinguish between the HRS and LRS states of a cell for a normal read. During a read operation, a cell current of the MRAM cell is higher for a cell in the LRS than the HRS. Note that, as used herein, the normal read reference may therefore correspond to a reference resistance, a reference current, or a reference voltage which can be used to differentiate between a "0" and a "1." For example, sense amplifiers, as known in the art, can determine whether the resistance of a selected (i.e. addressed) cell is higher or lower than the normal read reference resistance. This can be done by comparing a read current (Icell) provided from the selected cell being read to the reference current provided by a reference cell having the reference resistance, in which cells for which Icell is less than the reference current, the sense amplifier outputs a read data value of "1" and when Icell is greater than the reference current, the sense amplifier outputs a read data value of "0".

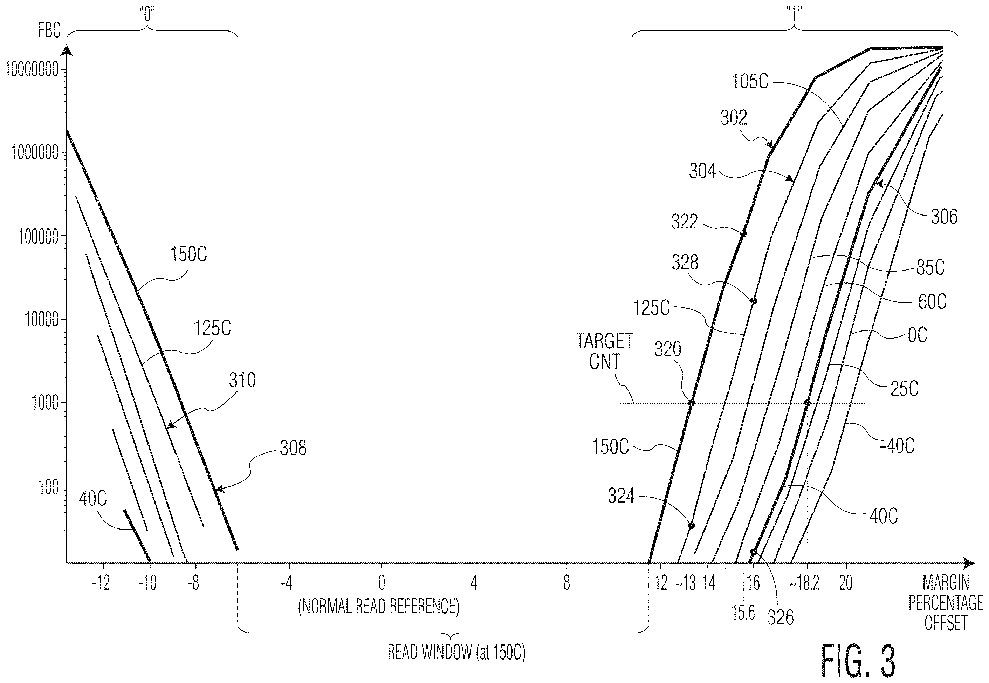

Still referring to FIG. 2, a read 0 margin corresponds to how much margin (e.g. resistance or current) is available between the edge of distribution 204 closest to distribution 206 and the normal read reference. Similarly, a read 1 margin corresponds to how much margin (e.g. resistance or current) is available between the edge of distribution 206 closest to distribution 204 and the normal read reference. In the illustrated embodiment, note that the normal read reference is selected to be half way between distributions 204 and 206 such that the read 0 and read 1 margins are substantially equal. However, in alternate embodiments, the normal read reference is selected such that the margins are not equal. The read window corresponds to the margin available between distributions 204 and 206 (e.g. the sum of the read 0 and read 1 margins). Distributions 204 and 206 and the corresponding read window of FIG. 2 correspond to the distributions at a particular temperature. However, as will be seen in FIG. 3, the read window varies with operating temperature, in which the window closes as a function of increasing temperature.

FIG. 3 illustrates a graph showing distributions of cells of an MRAM array (such as those of MRAM 106) of a failed bit count (FBC) versus a read reference percentage offset (as measured from the normal read reference described above in reference to FIG. 2) at different temperatures, in accordance with one embodiment of the present invention. The FBC can also be referred to as the bit error count, and can be used to indicate a bit error rate. The curves on the left side of FIG. 3, labeled as "0," represent the far right edges of "0" distributions (e.g. low resistance (Rp) distributions) at various temperatures (similar to distribution 204 of FIG. 2), and the curves on the right side of FIG. 3, labeled as "1," represent the far left edges of "1" distributions (e.g. high resistance (Rap) distributions) at various temperatures (similar to distribution 206 of FIG. 2). The line between the "0" distributions and "1" distributions is labeled as the normal read reference, and corresponds to a 0% margin percentage offset. Note that each curve of FIG. 3 represents a bit cell distribution at a particular temperature and therefore is labeled with a corresponding temperature value followed by "C" (which refers to a temperature value in Celsius). For example, "150C" refers to 150 degrees Celsius, "40C" to 40 degrees Celsius, "-40C" to -40 degrees Celsius, etc.

The vertical axis (Y-axis) represents the FBC on a logarithmic scale representing, at each tic mark going from the bottom to the top, an increase of 10x in the FBC (100 failed bits, 1000 failed bits, 10000, failed bits, etc.). Therefore, the FBCs correspond to a bit error rate (BER). The horizontal axis (X-axis) represents a margin percentage offset from the normal read reference (corresponding to a 0% offset), in which the references to the left of the normal read reference represent negative offset percentages with read reference resistances increasingly lower than the normal read reference resistance, while the references to the right of the normal read reference represent positive offset percentages with reference resistances increasingly greater than the normal read reference resistance. For example, an offset of 16% corresponds to using a margin read reference resistance that is 16% greater than the normal read reference resistance. Note that resistance which is 16% greater than normal read reference resistance corresponds to a current that is 16% lower than the normal read reference current. Note also that, as used herein, since the margin percentage offsets correspond to the normal read reference with a margin percentage offset, the margin percentage offsets may simply be referred to as margin read references (which are each offset from the normal read reference). Therefore, a "margin percentage offset" is used interchangeably with a "margin read reference."

Each curve of FIG. 3 represents a number of bit errors which occur when using a corresponding margin percentage offset. Using curve 302 as an example, which represents a "1" distribution at 150C, using a margin percentage offset of 4% or 8% results in no bit failures since curve 302 falls further right than the vertical lines at 4% or 8%. However, as the margin percentage offset increases further beyond 11%, the margin begins to cut into the distribution, indicating failures begin occurring. For example, curve 302 intersects with the margin offset of 13% at an FBC of 1000 (as indicated by dot 320). Curve 302 intersects with the margin offset of 15.6% at an FBC of 10000 (as indicated by dot 322). Therefore, as the margin offset increases, the bit error rate also increases. This is the case for each temperature. For example, curve 304 (which corresponds to 125C) intersects with margin offset 13% at an FBC that is less than 100 (as indicated by dot 324), but as the margin offset increases, the bit error rate increases. Note also that at a given offset percentage, the FBCs increase with increasing temperature. For example, at a margin offset of 16%, while at temperature 40C (represented by curve 306) the FBC count is low (almost zero, as indicated by dot 326), the FBC count at 125C is greater than 10000 (as indicated by dot 328).

Analogous trends occur in the "0" distributions, represented by the curves on the left of FIG. 3. At each temperature, as the margin offset decreases in percentage offset from the normal read reference, the distribution is cut off, resulting in a greater number of errors. Using curve 308 as an example, which represents a distribution of "0" cells at 150C, using a margin percentage offset of -4% results in no bit failures, but a margin of less than -6% margin offset begins to introduce bit failures. In this example, at -8%, the FBC is between 100 and 1000, but at -10%, the FBCs is just shy of 10,000. Similarly, at a given offset percentage, the FBCs increase with increasing temperature. For example, at a margin offset of -10%, the FBC count at temperature 150C (represented by curve 308) is greater than FBC count at temperature 125C (represented by curve 310).

Therefore, for each temperature represented in FIG. 3, as the read 1 margin increases (i.e. as the margin percentage offset increases to the right from the normal read reference), more of the distribution is cut off, resulting in a greater number of bit failures (an increase in FBC) for the "1" distributions. On the other hand, as the read 0 margin increases (i.e. as the margin percentage offset decreases to the left from the normal read reference), more of the distribution is cut off, resulting in a greater number of bit failures for the "0" distributions. Also, note, for either the "1" or "0" distributions, at each margin offset, the number of bit failures increases with increasing temperature.

The correlation (i.e. relationship) between selected temperatures and margin read references for a target FBC for each of the "1" and "0" distributions can be determined for each MRAM of an IC or for a group of MRAMs (such as MRAMs within ICs of a same wafer lot) and stored within an NVM or OTP of each IC during manufacture (e.g. during production testing). These correlations can then be used, during operation of the ICs in the field (after manufacture), to extrapolate temperature information. In this manner, the existing MRAM hardware, regardless of how it is programmed (regardless what type of code or user data is programmed into the array), can also be used as a temperature sensor. In using the MRAM to implement a temperature sensor, the customer code in the MRAM is arbitrary, as the temperature sensor is flexible with respect to the data loaded into the array. In one embodiment, BIST circuitry 110 uses MRAM 106 to output a temperature measurement by performing multiple reads (using both a normal read reference and a margin read reference that is offset from the normal read reference) over a selected address range to determine a read bit error rate. BIST circuitry 110 can then use the previously determined stored correlations to convert the determined read bit error rate to a calculated temperature.

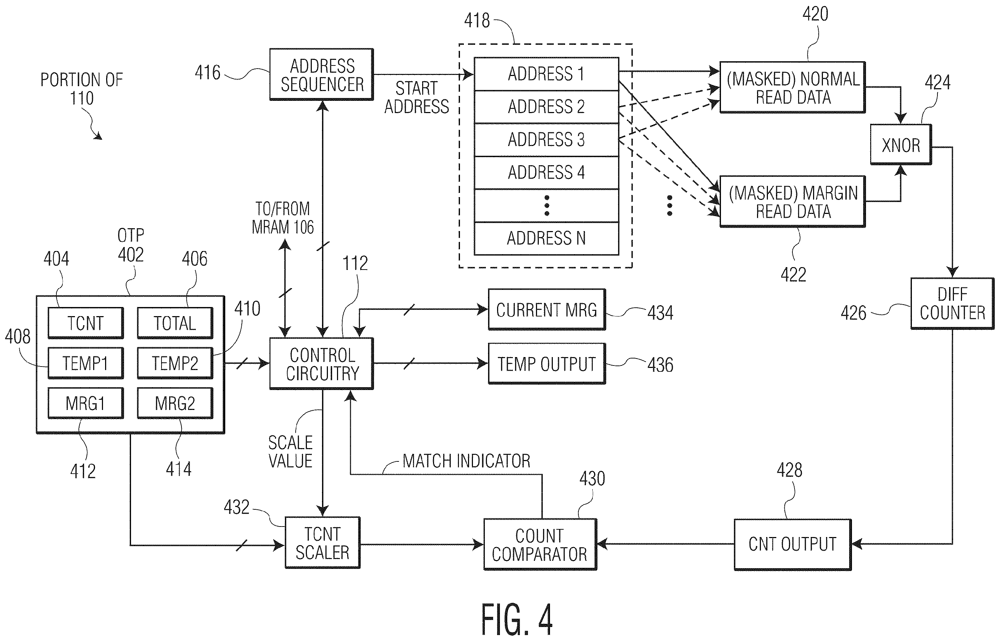

FIG. 4 illustrates a more detailed embodiment of BIST 110, in which control circuitry 112 communicates with an address sequencer 416, and directs the read sequence through a sequence 418 of N addresses, in which BIST 110 performs two reads from each address, one read being a normal read which uses the normal read reference to obtain normal read data and the other read being a margin read which uses a margin offset from the normal read reference to obtain margin read data. BIST 110 also includes storage circuitry (e.g. OTP memory 402) configured to store various temperature sensing parameters, storage circuitry (e.g. registers) configured to store a current margin (MRG) 434 and a calculated temperature output 436, a scaler 432, a count comparator 430, XNOR logic 424, a difference counter 426, and storage circuitry (e.g. a register) configured to store a count (CNT) output 428.

The temperature sensing parameters stored within OTP 402 includes a first temperature (TEMP1) 408, a second temperature (TEMP2) 410, a first margin level (MRG1) 412 corresponding to the read margin used for TEMP1, a second margin level (MRG2) 414 corresponding to the read margin used for TEMP2, a total count (TCNT) 404 which corresponds to an error count value previously determined at TEMP1, and a total bit count (TOTAL) 406 which corresponds to a total number of bit cells read in obtaining TCNT. These parameters therefore correspond to stored margin and temperature correlations, in which alternate embodiments may store additional parameters or fewer parameters. Each of these values can be loaded into registers of control circuitry 112, as needed, from OTP 402 upon wake-up or reset of IC 100 for use during temperature sensing by BIST 110. Therefore, OTP 402 may be located within BIST 110, within MRAM 106, or elsewhere within IC 100. Also, in one embodiment, the values illustrated in OTP 402 correspond to the values previously obtained for a "1" distribution, and a second set of values may be stored in OTP 402 which correspond to the values previously obtained for a "0" distribution.

In one embodiment, TEMP1 corresponds to a lowest temperature recorded (e.g. 40C) when TCNT was obtained, and TEMP2 corresponds to a highest temperature recorded (e.g. 150C). Therefore, referring to FIG. 3 as examples, during manufacture of IC 100, production testing was performed to determine the bit cell distributions at various temperatures. In the illustrated embodiment of FIG. 4, the production testing for determining the FBCs was performed at 40C and 150C to determine the proper margin required to obtain a target FBC (e.g. 1000) at each temperature. For example, at 150C, curve 302 (which would have been obtained during the production testing of MRAM 106) indicates that a margin offset percentage of about 13% (labeled as ~13 on FIG. 3) corresponds to the target FBC of 1000. Similarly, for 40C, curve 306 (also obtained during the production testing) indicates that a margin percentage of about 18.2% (labeled as ~18.2) corresponds to the target FBC of 1000. For ease of description, it will be assumed that the margin offset percentages for achieving an FBC of 1000 corresponds to 18.2% at TEMP1 and 13% at TEMP2. Therefore, in this example, for the "1" distribution, TCNT 404 is stored as 1000, TEMP1 408 as 40C, MRG1 412 as 18.2%, TEMP2 410 as 150C, and MRG2 414 as 13%. In one embodiment, the total number of bits read to obtain MRG1 412 and TEMP1 408 is stored in TOTAL 406, which can be used to obtain the bit error fail rate at TEMP1 (e.g. fail rate = TCNT/TOTAL). (Note that similar testing at manufacture may be performed and captured in OTP 402 for the "0" distribution.)

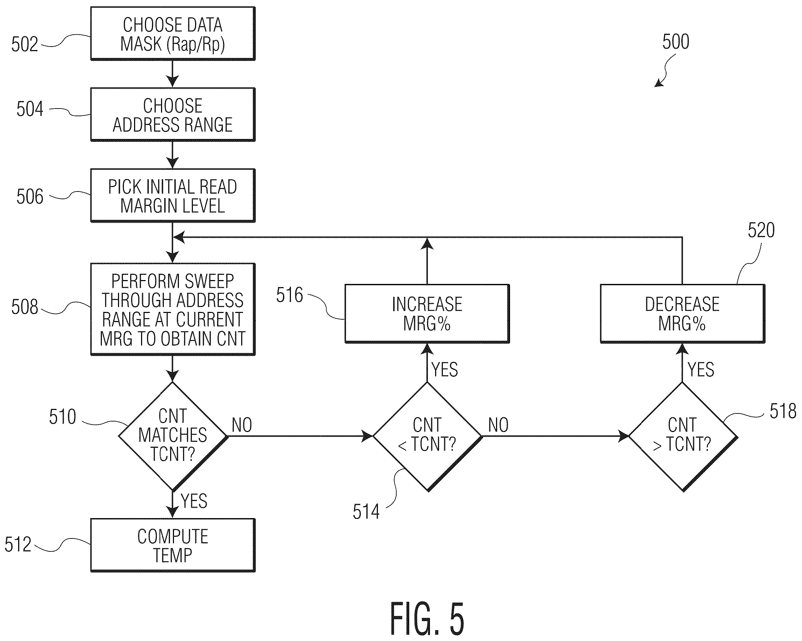

Use of the parameters in OTP 402 will be described in reference to the elements of BIST 110 of FIG. 4 and the flow diagram of FIG. 5, in which FIG. 5 illustrates a flow diagram of a temperature sensing method 500 which is performed by BIST 110 using MRAM 106 and the values stored in OTP 402 described in the example above. Method 500 begins with block 502 in which the proper data mask is selected for the temperature sensing (either the Rap data, corresponding to the "1" distribution, or the Rp data, corresponding to the "0" distribution). In the illustrated embodiment, it will be assumed that the "1" distribution (the Rap data) is desired for the temperature sensing, therefore a mask is determined, as known in the art, to obtain the "1"s of a data element. Had the "0" distribution instead been selected, then a mask is determined, as known in the art, to obtain the "0"s of a data element. Note that in alternate embodiments, such as if it is known that the data heavily stores bits of the desired state, method 500 can be performed without applying any masking.

Next, at block 504, an address range with MRAM 106 is selected, and, at block 506, an initial read margin level (MRG) is selected with which to perform the margin read. Referring back to FIG. 4, the selected address range is indicated to address sequencer 416 which will cycle through the addresses in the address range, and the selected read margin level (corresponding to a selected margin percentage offset) is stored as current MRG 434. Next, at block 508, a sweep is performed through the addresses of the address range using the selected read margin level (at current MRG 434) to obtain a count value (CNT) of bit errors. BIST 110, at each address, directs both a normal read and margin read from the address by generating read accesses to MRAM 106, in which MRAM 106 returns normal read data to BIST 110 in response to the normal read access and returns margin read data to BIST 110 in response to the margin read access.

For example, referring to FIG. 4, address sequencer 416 generates the addresses of address sequence 418, beginning with a start address, Address 1. Control circuitry 112 generates a normal read access to Address 1 of MRAM 106 to obtain normal read data, in which the normal read reference is used by the sense amplifiers of the read circuitry of MRAM 106 to obtain the normal read data 420. Control circuitry 112 also generates a margin read access to the same Address 1 of MRAM 106 to obtain margin read data 422, in which the margin read reference is determined based on the selected margin percentage offset stored in current MRG 434 and is used by the sense amplifiers of the read circuitry of MRAM 106 to obtain margin read data. (Note that, in one embodiment, each of the normal read data and the margin read data can be masked by the mask generated in block 502 for isolating the "1"s in the read data.) After both reads from Address 1 are performed (and masked, if needed), XNOR logic 424 is used to perform a bit-wise XNOR comparison between them, in which the result for each bit comparison is a "1" if the corresponding bit values being compared match and a "0" if they are different (which indicates an error in that bit position). Diff counter 426 counts the differences provided by XNOR logic 424 (i.e. counts the number of bits which mismatched). This value is then added to the CNT value of CNT output 428 to keep a running total of a number of bit errors during the current address sweep.

In the current example, it is assumed that the total number of bits being read in the sweep of address sequence 418 is the same as the number of bits indicated by TOTAL 406. In this case, at each of decision diamonds 510, 514, and 518, the running count value indicated by CNT output 428 is compared directly to TCNT 404. Therefore, after performing the sweep through the N addresses of address sequence 418, in which two reads are performed to obtain normal read data and margin read data from each address, the running count value indicated by CNT output 428 is compared to TCNT 404. If they match, then method 500 proceeds to block 512 in which the sensed temperature can be calculated and provided as TEMP output 436. However, if at decision diamond 510, the CNT output 428 is lower than TCNT, then the read margin percentage offset is increased by a step value in block 516, or, if the CNT output 428 is greater than TCNT at decision diamond 518, then the read margin percentage offset is decreased by a step value in block 520. Therefore, in the case that CNT does not match TCNT at decision diamond 510, the read margin offset percentage is adjusted (increased or decreased) and stored as current MRG 434, and method 500 returns to block 508 to repeat the sweep through address sequence 418, but instead using the adjusted read margin percentage offset to obtain the margin read data for each address. (Note also that prior to each address sweep at a particular read margin level, the CNT output 428 is cleared.)

Note that, as used herein, determining whether the running count value indicating by CNT output 428 matches TCNT 404 may not require that the values match exactly but that they be within a predetermined margin of error (e.g. a predetermined percentage) of each other. For example, CNT output 428 may be deemed as matching (or as achieving) TCNT 404 if CNT output 428 is within a predetermined percentage (X%) above or below TCNT 404 (i.e. CNT may match or achieve TCNT if it falls within TCNT +/- X%).

Once the read margin percentage offset (i.e. read margin reference) is determined which results in CNT output 428 matching TCNT (as indicated by match indicator output by count comparator 430 of FIG. 4), then this current MRG value can be used to interpolate the temperature value using the stored values of TEMP1 408, MRG1 412, TEMP2 410, and MRG2 414. For example, the calculated temperature output as TEMP output 436 (i.e. TEMP OUT) can be calculated with the following equation:

$$\text{TEMP OUT} = \text{TEMP1} + ((\text{TEMP2}-\text{TEMP1})/(\text{MRG2}-\text{MRG1}))*(\text{current MRG} - \text{MRG1})$$

As an example, referring to FIG. 3, and assuming TEMP1 corresponds to 40C with MRG1 corresponding to a read margin offset percentage of 18.2%, and TEMP2 corresponds to 150C with MRG2 corresponding to a read margin offset percentage of 13%, during operation, method 500 of FIG. 5 may select any margin value to use as the initial margin value during the first address sweep (during the initial run of block 508) which falls between MRG1 and MRG2. The desired or target bit error (FBC) is indicated by TCNT 404, and, in this example, it is assumed that TCNT is 1000. Therefore, the values of the margin read reference (i.e. the margin percentage offset) will be adjusted for each sweep until the target FBC value of 1000 is reached.

As an example, it is assumed that control circuitry 112 selects 16% as a starting point for the margin offset percentage. Through the first iteration through block 508, the margin reads from each address of the address sweep will be performed using the margin percentage offset of 16%. Depending on the operating temperature of MRAM 106 (which is currently being determined), the CNT output from the address sweep may provide a value that is greater than 1000 or less than 1000. For example, if the MRAM happens to be operating at a higher temperature (such as at a temperature of 105C or greater), the resulting CNT output would be greater than 1000, but if the MRAM happens to be operating at a lower temperature (such as at 85C), then the resulting CNT output would be less than 1000. This can be seen by following the vertical dashed line labeled 306 of FIG. 3 placed at the margin percentage offset of 16%. Therefore, if the resulting CNT after a sweep is higher than TCNT, for the next iteration through the address sweep of block 508, the margin read reference is adjusted by reducing the margin percentage offset. For example, it may be reduced by a step size of 2 percentage points down to 14% for the next address sweep. After the next sweep, if the resulting count value is still too high, the margin percentage offset can be reduced again, or, if the value is now too low, it can be increased by a smaller step size. This incremental adjusting by increasing or decreasing the margin percentage offset after each address sweep is continued until a sweep results in a CNT value which matches TCNT. At this point, the margin percentage offset resulting in the target FBC has been determined (indicating that a target bit error rate has been achieved), and the temperature can then be extrapolated (i.e. calculated) based on the temperature and margin correlations previously stored in OTP 402. For example, if the margin percentage offset which achieves the target FBC is 14%, then it is known that the sensed temperature is about 140C (between the value of 150C and 125C). This temperature can be more accurately determined by performing the temperature extrapolation using the stored correlations (i.e. relationships) between TEMP1 and MRG1 and between TEMP2 and MRG2, as described above.

In the above example, it was assumed that the total number of bits read by the address range was the same as TOTAL 406, such that no scaling is necessary when comparing the resulting CNT after each sweep to TCNT 404. However, if control circuitry 112 selects an address range which results in a number of read bits less than TOTAL, then, prior to comparing the running CNT value after each sweep to TCNT 402, TCNT 402 can first be scaled. For example, the desired error rate indicated by TCNT 402 and TOTAL 406 is "TCNT/TOTAL". Therefore, in one embodiment, TCNT scaler 432 scales TCNT 402 by the desired error rate before being provided to count comparator 430 to compare with CNT output 428. (In one embodiment, BIST 110 may include an additional counter to count the number of bits being read to determine if number of bits read reaches TOTAL or not.) In one embodiment, the scale value based on TCNT and TOTAL can be provided as a scale value by control circuitry 112 to TCNT scaler 432. Note that, as indicated above, if the address range provides the full TOTAL number of read bits, then TCNT can be provided directly to count comparator 430 for comparison with CNT output 428 (or the scale value can be set to one). In another embodiment, a target bit error rate (i.e. target bit fail rate) may be stored or used rather than or in addition to TCNT 404, and CNT output 428 can be converted to a bit error rate as well, in which, rather than comparing CNT or a scaled CNT for the sweep to TCNT, a bit error rate for the sweep can be compared to the target bit error rate. Therefore, note that TCNT indicates a target bit error rate (BER), and the comparisons performed using CNT output 428 and TCNT (e.g. at decision diamonds 510, 514, and 418) to determine whether or not to modify current MRG 434 can be done in a variety of different ways to determine whether or not the target BER has been achieved. And as indicated above, regardless of which values are compared (counts or BERs), determining a match (or determining whether a target value has been achieved), refers to determining whether the value falls within a predetermined percentage of a target value, e.g. within a target BER +/X%).

Since portions of BIST circuitry 110 are capable of performing temperature sensing using MRAM 106, BIST circuitry 110 may also be referred to as a temperature sensor or temperature sensing circuitry. Note that any method of adjusting the margin percentage offset after a sweep can be implemented to find the resulting margin level which results in the target FBC. For example, any type of search method can be implemented in adjusting the margin percentage offset, such as, e.g., a binary search method. However, other embodiments may implement different search methods.

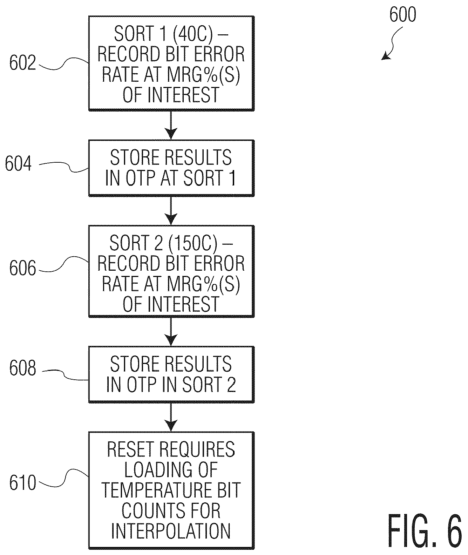

FIG. 6 illustrates, in flow diagram form, a method 600 of determining the margin and temperature correlations for an MRAM during production testing, in accordance with an embodiment of the present invention. The production testing can be done during or upon completion of the manufacturing of the MRAM or the IC containing the MRAM. It can be done, for example, on a wafer basis based on sorts (in which each sort corresponds to a testing run on a wafer or set of wafers). Note that other tests can be performed during production testing. For the illustrated embodiment, it is assumed that the production testing results in determining and storing the values of OTP 402 for MRAM 106.

Method 600 begins with block 602 in which a first sort (e.g. testing run) is performed at a first temperature (e.g. 40C). This results, for example, in data points corresponding to a curve (such as curve 306), and from this testing run, the bit error rate at one or more margin percentage offsets of interest are recorded and stored. Next, at block 604, the desired results from the first sort are stored in OTP 402. For the examples described above, this would include storing the margin percentage offset of 18.2% as MRG1 and 40C as TEMP1 in OTP 402, as well as storing the FBC of 1000 as TCNT 404, and, if desired, the total number of bits tested by the first sort as TOTAL 406. Then, at some time later, at block 606, a second sort is performed at a second temperature (e.g. 150C). (Note that the sorts can be performed in different orders, and that any number of sorts may be performed between the first and second sorts of FIG. 6, as needed.) The second sort results, for example, in data points corresponding to a curve (such as curve 302), and from this testing run, the bit error rate at one or more margin percentage offsets of interest are recorded and stored. Next, at block 608, the desired results from the second sort are stored in OTP 402. For the examples described above, this would include storing the margin percentage offset of 13% as MRG2 and 150C as TEMP2 in OTP 402. Note that, at some time later when operating MRAM 106 (IC 100), such as during operation in the field, upon a reset of IC 100, the values of OTP 402 can be loaded by control circuitry 112 for use by BIST 110 for temperature sensing with MRAM 106.

Therefore, by now it can be appreciated that there has been provided a temperature sensor implemented with an MRAM, in which the MRAM can be programmed with any values. That is, the MRAM, as programmed for normal operation, can be used to implement the temperature sensor without needing to store a particular or known data pattern. During temperature sensing, as performed and controlled by a BIST circuit, address sweeps at selected margin read references are performed by, at each sweep, sequencing through a range of addresses in which both a normal read and a margin read are performed at each address. The reads are compared, and a number of bit errors as a result of comparing the reads is stored during each sweep. If the bit errors counted at the end of a sweep does not match a target count value (e.g. TCNT), then the margin read reference is adjusted and an address sweep is again performed. This continues until the number of bit errors at the end of a sweep matches the target count value. This resulting read margin value can then be used in combination with previously obtained margin/temperature relationships (i.e. correlations) for the MRAM obtained from an NVM/OTP to calculate a current temperature of the MRAM (and thus of the IC containing the MRAM). This temperature sensing provides flexibility by reusing an existing MRAM, without affecting its data, and not requiring additional temperature sensing hardware.

Built-in self-test circuitry is configured to calculate a sensed temperature using an MRAM and a stored set of margin read reference and temperature correlations for a target bit error rate. A current margin read reference is selected, and a sweep through a sequence of addresses of the MRAM is performed using the current margin read reference. At each address of the sequence, a normal read is performed to obtain normal read data and a margin read is performed to obtain margin read data. A bit error count is obtained for the sweep based on comparisons between the normal and margin read data obtained at each address, and the current margin read reference is selectively modified based on whether or not the bit error count achieves the target bit error rate. The selectively modified current margin read reference and the stored set of correlations are used to calculate the sensed temperature.

The terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Each signal described herein may be designed as positive or negative logic, where negative logic can be indicated by a bar over the signal name or an asterisk (*) following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Some of the above embodiments, as applicable, may be implemented using a variety of different information processing systems. For example, although FIG. 1 and the discussion thereof describe an exemplary information processing architecture, this exemplary architecture is presented merely to provide a useful reference in discussing various aspects of the invention. Of course, the description of the architecture has been simplified for purposes of discussion, and it is just one of many different types of appropriate architectures that may be used in accordance with the invention. Those skilled in the art will recognize that the boundaries between logic blocks are merely illustrative and that alternative embodiments may merge logic blocks or circuit elements or impose an alternate decomposition of functionality upon various logic blocks or circuit elements.

Thus, it is to be understood that the architectures depicted herein are merely exemplary, and that in fact many other architectures can be implemented which achieve the same functionality. Also for example, in one embodiment, the illustrated elements of system 100 are circuitry located on a single integrated circuit or within a same device. Alternatively, system 100 may include any number of separate integrated circuits or separate devices interconnected with each other. For example, memory 106 may be located on a same integrated circuit as processor 104 or on a separate integrated circuit. Some or all of peripherals 108 may also be located on separate integrated circuits or devices.

Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, different control fields in the state machine entries may be used to modify different sets of parameters before each operation of a test sequence. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention.

In an embodiment, an integrated circuit includes a magnetoresistive random access memory (MRAM); a non-volatile memory (NVM) configured to store a set of margin read reference and temperature correlations for a target bit error rate; and built-in self-test (BIST) circuitry configured to calculate a sensed temperature. The BIST circuitry includes an address sequencer configured to generate a sequence of addresses of the MRAM; and control circuitry configured to select a current margin read reference, perform a sweep through the sequence of addresses using the current margin read reference wherein, at each address, the control circuitry is configured to direct a normal read from the address to obtain normal read data from the MRAM and a margin read from the address to obtain margin read data from the MRAM, obtain a bit error count for the sweep based on comparisons between the normal read data and the margin read data obtained at each address of the sequence of addresses, selectively modify the current margin read reference based on whether or not the bit error count achieves the target bit error rate, and using the selectively modified current margin read reference and the set of margin read reference and temperature correlations for the target bit error rate to calculate the sensed temperature. In one aspect of the embodiment, the set of margin read reference and temperature correlations for the target bit error rate includes a first temperature value and a first margin read reference value which correspond to target bit error rate; and a second temperature value, different from the first temperature value, and a second margin read reference value, different from the first margin read reference value, which correspond to the target bit error rate. In a further aspect, performing reads from the MRAM using the first margin read reference value at the first temperature value results in the target bit error rate, and performing reads from the MRAM using the second margin read reference value at the second temperature value results in the target bit error rate. In another further aspect, the NVM is configured to store a target bit error count corresponding to the target bit error rate. In yet a further aspect, the NVM is configured to store a total number of bits, wherein the target bit error count divided by the total number of bits corresponds to the target bit error rate. In another further aspect, an initial value of the current margin read reference is set to a value between the first and second margin read reference values. In another aspect of the embodiment, for the sweep, the normal reads are each performed by the MRAM using a normal read reference value and the margin reads are each performed by the MRAM using a margin read reference value determined by the current margin read reference. In a further aspect, the margin read reference value is offset from the normal read reference value, wherein the offset is indicated by current margin read reference. In another aspect, the control circuitry is further configured to, when the current margin read reference is modified, repeat the performing the sweep, the obtaining the bit error count for the sweep, and the selectively modifying the current margin read reference. In a further aspect, the control circuitry is configured to, when the bit error count achieves the target bit error rate, not further modify the current margin read reference prior to the using the selectively modified current margin read reference to calculate the sensed temperature. In another aspect, the control circuitry is configured to implement interpolation of temperatures with the set of margin read reference and temperature correlations to calculate the sensed temperature with the selectively modified current margin read reference. In another aspect, the control circuitry includes a difference counter which counts, for each address of the sweep, a number of bit mismatches which occur between the normal read data and the margin read data, wherein the bit error count is updated after each address of the sweep based on the difference counter. In a further aspect, the control circuitry is further configured to, for each address of the sweep, apply a mask to each of the normal read data and the margin read data prior to determining the number of bit mismatches.

In another embodiment, an integrated circuit includes a magnetoresistive random access memory (MRAM); a non-volatile memory (NVM) configured to store an indication of a target bit error rate and a set of margin read reference and temperature correlations for the target bit error rate; and built-in self-test (BIST) circuitry configured to perform temperature sensing by iteratively adjusting and using a margin read reference to obtain margin read data from the MRAM until a bit error rate of the MRAM achieves the target bit error rate, wherein each adjusted margin read reference is at a different offset from a normal read reference, and outputting a sensed temperature of the integrated circuit by using a resulting value of the iteratively adjusted margin read reference which resulted in the MRAM achieving the target bit error rate to calculate the sensed temperature. In one aspect of the another embodiment, the BIST circuitry calculates the sensed temperature corresponding to the resulting value of the iteratively adjusted margin read reference by interpolating between temperatures of the set of margin read reference and temperature correlations stored in the NVM. In another aspect, the BIST circuitry is configured to obtain the bit error rate of the MRAM after each adjustment of the margin read reference by comparing normal read data obtained from each address of a plurality of addresses using the normal read reference to margin read data obtained from each address of the plurality of addresses using the adjusted margin read reference. In another aspect, the indication of the target bit error rate and the set of margin read reference and temperature correlations for the target bit error rate are stored in the NVM during production testing, prior to field operation of the integrated circuit.

In yet another embodiment, in an integrated circuit having a magnetoresistive random access memory (MRAM), a method to sense a temperature of the MRAM includes selecting a current margin read reference; performing a sweep through a sequence of addresses using the current margin read reference wherein, at each address, a normal read from the address is performed to obtain normal read data from the MRAM using a normal read reference value and a margin read from the address is performed to obtain margin read data from the MRAM using a margin read reference value determined from the current margin read reference, wherein the margin read reference value is offset from the normal read reference value; determining a bit error count for the sweep based on comparisons between the normal read data and the margin read data obtained at each address of the sequence of addresses; selectively modifying the current margin read reference based on whether or not the bit error count achieves the target bit error rate; and calculating the sensed temperature using the selectively modified current margin read reference and the set of margin read reference and temperature correlations for the target bit error rate. In one aspect of the yet another embodiment, the method further includes, when the current margin read reference is modified, repeating the performing the sweep, the determining the bit error count for the sweep, and the selectively modifying the current margin read reference. In another aspect, the determining the bit error count for the sweep includes, for each address of the sweep, counting a number of bit mismatches which occur between the normal read data and the margin read data, and updating the bit error count based on the number of bit mismatches.

**Claims**

1.  An integrated circuit, comprising:

    a magnetoresistive random access memory (MRAM);
    a non-volatile memory (NVM) configured to store a set of margin read reference and temperature correlations for a target bit error rate; and
    built-in self-test (BIST) circuitry configured to calculate a sensed temperature, the BIST circuitry comprising:

    an address sequencer configured to generate a sequence of addresses of the MRAM; and
    control circuitry configured to:

    select a current margin read reference,
    perform a sweep through the sequence of addresses using the current margin read reference wherein, at each address, the control circuitry is configured to direct a normal read from the address to obtain normal read data from the MRAM and a margin read from the address to obtain margin read data from the MRAM,
obtain a bit error count for the sweep based on comparisons between the normal read data and the margin read data obtained at each address of the sequence of addresses,
selectively modify the current margin read reference based on whether or not the bit error count achieves the target bit error rate, and
use the selectively modified current margin read reference and the set of margin read reference and temperature correlations for the target bit error rate to calculate the sensed temperature.

2. The integrated circuit of claim 1, wherein the set of margin read reference and temperature correlations for the target bit error rate comprises:

a first temperature value and a first margin read reference value which correspond to target bit error rate; and
a second temperature value, different from the first temperature value, and a second margin read reference value, different from the first margin read reference value, which correspond to the target bit error rate.

3. The integrated circuity of claim 2, wherein performing reads from the MRAM using the first margin read reference value at the first temperature value results in the target bit error rate, and performing reads from the MRAM using the second margin read reference value at the second temperature value results in the target bit error rate.

4. The integrated circuity of claim 2 or 3, wherein the NVM is configured to store a target bit error count corresponding to the target bit error rate.

5. The integrated circuit of claim 4, wherein the NVM is configured to store a total number of bits, wherein the target bit error count divided by the total number of bits corresponds to the target bit error rate.

6. The integrated circuit of any of claims 2 to 5, wherein an initial value of the current margin read reference is set to a value between the first and second margin read reference values.

7. The integrated circuit of any preceding claim, wherein, for the sweep, the normal reads are each performed by the MRAM using a normal read reference value and the margin reads are each performed by the MRAM using a margin read reference value determined by the current margin read reference.

8. The integrated circuit of claim 7, wherein the margin read reference value is offset from the normal read reference value, wherein the offset is indicated by current margin read reference.

9. The integrated circuit of any preceding claim, wherein the control circuitry is further configured to, when the current margin read reference is modified, repeat the performing the sweep, the obtaining the bit error count for the sweep, and the selectively modifying the current margin read reference.

10. The integrated circuit of claim 9, wherein the control circuitry is configured to, when the bit error count achieves the target bit error rate, not further modify the current margin read reference prior to the using the selectively modified current margin read reference to calculate the sensed temperature.

11. The integrated circuit of any preceding claim, wherein the control circuitry is configured to implement interpolation of temperatures with the set of margin read reference and temperature correlations to calculate the sensed temperature with the selectively modified current margin read reference.

12. The integrated circuit of any preceding claim, wherein the control circuitry comprises a difference counter which counts, for each address of the sweep, a number of bit mismatches which occur between the normal read data and the margin read data, wherein the bit error count is updated after each address of the sweep based on the difference counter.

13. The integrated circuit of claim 12, wherein the control circuitry is further configured to, for each address of the sweep, apply a mask to each of the normal read data and the margin read data prior to determining the number of bit mismatches.

14. In an integrated circuit having a magnetoresistive random access memory (MRAM), a method to sense a temperature of the MRAM, comprising:

selecting a current margin read reference;

performing a sweep through a sequence of addresses using the current margin read reference wherein, at each address, a normal read from the address is performed to obtain normal read data from the MRAM using a normal read reference value and a margin read from the address is performed to obtain margin read data from the MRAM using a margin read reference value determined from the current margin read reference, wherein the margin read reference value is offset from the normal read reference value;

determining a bit error count for the sweep based on comparisons between the normal read data and the margin read data obtained at each address of the sequence of addresses;

selectively modifying the current margin read reference based on whether or not the bit error count achieves the target bit error rate; and

calculating the sensed temperature using the selectively modified current margin read reference and the set of margin read reference and temperature correlations for the target bit error rate.

15. The method of claim 14, further comprising:

when the current margin read reference is modified, repeating the performing the sweep, the determining the bit error count for the sweep, and the selectively modifying the current margin read reference.

FIG. 1

EP 4 726 720 A1

FIG. 2

FIG. 3

EP 4 726 720 A1

FIG. 4

EP 4 726 720 A1

FIG. 5

602 —— SORT 1 (40C) – RECORD BIT ERROR RATE AT MRG%(S) OF INTEREST

604 —— STORE RESULTS IN OTP AT SORT 1

606 —— SORT 2 (150C) – RECORD BIT ERROR RATE AT MRG%(S) OF INTEREST

608 —— STORE RESULTS IN OTP IN SORT 2

610 —— RESET REQUIRES LOADING OF TEMPERATURE BIT COUNTS FOR INTERPOLATION

600

FIG. 6

EUROPEAN SEARCH REPORT

**Application Number**

EP 25 20 7229

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WU YU'ANG ET AL: "A Novel Segmented Temperature Monitor for Adaptive MRAM", 2022 IEEE INTERNATIONAL CONFERENCE ON INTEGRATED CIRCUITS, TECHNOLOGIES AND APPLICATIONS (ICTA), IEEE, [Online] 28 October 2022 (2022-10-28), pages 70-71, XP034240612, DOI: 10.1109/ICTA56932.2022.9963137 Retrieved from the Internet: URL:https://ieeexplore.ieee.org/document/9963137/> [retrieved on 2026-01-21] * the whole document * | 1-15 | INV. G11C7/04 G11C11/16 G11C29/02 G11C29/42 ADD. G11C29/20 G01K7/16 |
| | ----- | | |
| A | ZHOU Y ET AL: "A novel BIST for monitoring aging/temperature by self-triggered scheme to improve the reliability of STT-MRAM", MICROELECTRONICS RELIABILITY : AN INTERNAT. JOURNAL & WORLD ABSTRACTING SERVICE, ELSEVIER SCIENCE LTD, GB, [Online] vol. 114, 31 October 2020 (2020-10-31), XP086356583, ISSN: 0026-2714, DOI: 10.1016/J.MICROREL.2020.113735 Retrieved from the Internet: URL:https://www.sciencedirect.com/science/article/pii/S0026271420304388> [retrieved on 2026-01-21] * the whole document * | 1-15 | |
| | ----- | | **TECHNICAL FIELDS SEARCHED (IPC)** G11C G01W G01K |
| | -/-- | | |

The present search report has been drawn up for all claims

| Place of search | Date of completion of the search | Examiner |
|---|---|---|
| The Hague | 23 January 2026 | Vlachogiannakis, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

page 1 of 2

Europäisches
Patentamt

European
Patent Office

Office européen
des brevets

## EUROPEAN SEARCH REPORT

**Application Number**

EP 25 20 7229

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WANG SHAODI ET AL: "Adaptive MRAM Write and Read with MTJ Variation Monitor", IEEE TRANSACTIONS ON EMERGING TOPICS IN COMPUTING, IEEE, USA, [Online] vol. 9, no. 1, 19 August 2018 (2018-08-19), pages 402-413, XP011841710, DOI: 10.1109/TETC.2018.2866289 Retrieved from the Internet: URL:https://ieeexplore.ieee.org/document/8440727> [retrieved on 2026-01-21] * the whole document * | 1-15 | |

-----

TECHNICAL FIELDS
SEARCHED       (IPC)

The present search report has been drawn up for all claims

| Place of search | Date of completion of the search | Examiner |
|---|---|---|
| The Hague | 23 January 2026 | Vlachogiannakis, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)